# EUROPÄISCHE PATENTANMELDUNG

(11) **EP 1 375 047 A1**
(43) Veröffentlichungstag der Anmeldung: **02.01.2004**
(21) Anmeldenummer: 02013699.0
(22) Anmeldetag: 20.06.2002
(51) Int. Cl.: B23K 20/00, B23K 20/24, H01L 21/607

(54) **Vorrichtung mit Elektroden für die Bildung einer Kugel am Ende eines Drahts**

(71) Anmelder: Esec Trading S.A., 6330 Cham (CH)
(72) Erfinder: Felber, Armin, 6003 Luzern (CH)
(74) Vertreter: Falk, Urs, Dr.

(57) **Zusammenfassung**

Eine Vorrichtung mit Elektroden für die Bildung einer Kugel am Ende eines aus einer Kapillare (3) herausragenden Drahtes (2) umfasst eine erste Elektrode (6), die mit einer Spitze (9) versehen ist, und mindestens eine weitere Elektrode (7; 8). Die erste Elektrode (6) und die mindestens eine weitere Elektrode (7) sind elektrisch verbunden. Der Abstand zwischen der Spitze (9) der ersten Elektrode (6) und dem Ende des Drahtes (2) grösser ist als der Abstand zwischen einem beliebigen Punkt der mindestens einen weiteren Elektrode (7; 8) und dem Ende des Drahtes (2).

## Beschreibung

Die Erfindung betrifft eine Vorrichtung mit Elektroden für die Bildung einer Kugel am Ende eines Drahtes der im Oberbegriff des Anspruchs 1 genannten Art.

Solche Vorrichtungen werden auf sogenannten Wire Bondern verwendet. Ein Wire Bonder ist eine Maschine, mit der Halbleiterchips nach deren Montage auf einem Substrat verdrahtet werden. Der Wire Bonder weist eine Kapillare auf, die an der Spitze eines Horns eingespannt ist. Die Kapillare dient zum Befestigen des Drahtes auf einem Anschlusspunkt des Halbleiterchips und auf einem Anschlusspunkt des Substrates sowie zur Drahtführung zwischen den beiden Anschlusspunkten. Bei der Herstellung der Drahtverbindung zwischen dem Anschlusspunkt des Halbleiterchips und dem Anschlusspunkt des Substrates wird das aus der Kapillare ragende Drahtende zunächst zu einer Kugel geschmolzen. Anschliessend wird die Drahtkugel auf dem Anschlusspunkt des Halbleiterchips mittels Druck und Ultraschall befestigt. Dabei wird das Horn von einem Ultraschallgeber mit Ultraschall beaufschlagt. Diesen Prozess nennt man Ball-bonden. Dann wird der Draht auf die benötigte Drahtlänge durchgezogen, zu einer Drahtbrücke geformt und auf dem Anschlusspunkt des Substrates verschweisst. Diesen letzten Prozessteil nennt man Wedge-bonden. Nach dem Befestigen des Drahtes auf dem Anschlusspunkt des Substrats wird der Draht abgerissen und der nächste Bondzyklus kann beginnen.

Um das aus der Kapillare herausragende Ende des Drahtes zu einer Kugel zu formen, wird zwischen dem Draht und der Elektrode eine DC-Hochspannung angelegt, so dass ein elektrischer Funken entsteht, der den Draht aufschmilzt. Die Spannung, bei der der elektrische Durchschlag der ionisierten Luft zwischen dem Draht und der Elektrode erfolgt und sich der Funken bildet, wird als Funkenspannung bezeichnet.

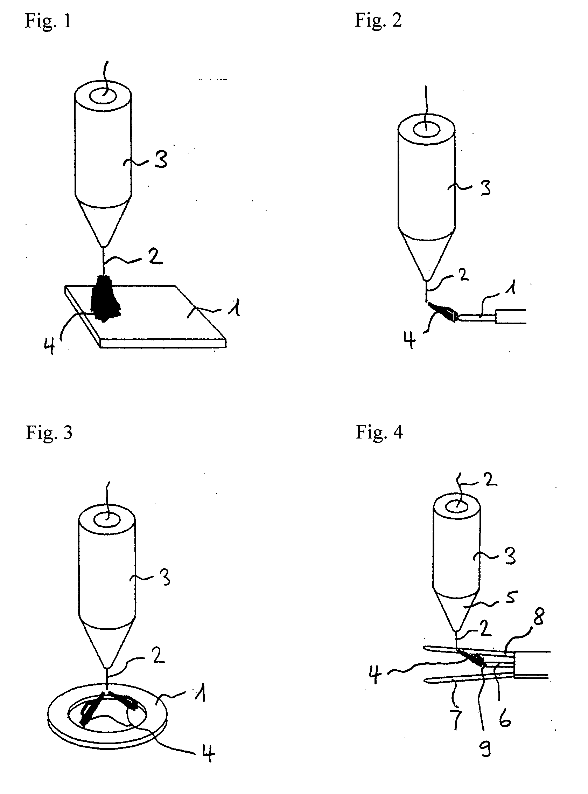

Heutzutage sind drei Typen von Vorrichtungen für die Bildung einer Drahtkugel (engl. ball) am Ende eines Drahtes bekannt, die sich im Markt durchgesetzt haben. Diese drei Typen werden anhand der Figuren 1 bis 3 erläutert. Beim ersten Typ (Fig. 1) wird eine flache Elektrode 1 von der Seite her unter die den Draht 2 führende Kapillare 3 eingeschwenkt. Bei dieser Anordnung von Elektrode und Draht bildet sich der elektrische Funken 4 in Längsrichtung des Drahtes aus. Der elektrische Funken 4 verläuft somit symmetrisch zum Draht. Der Vorteil dieses Typs ist, dass die Symmetrie der gebildeten Kugel vergleichsweise hoch ist. Nachteilig ist hingegen, dass das Ein- und Ausschwenken der Elektrode Zeit kostet.

Beim zweiten Typ (Fig. 2) ist eine Elektrode 1 mit einer Spitze seitlich versetzt unterhalb der Kapillare angeordnet. Bei dieser Anordnung verläuft der elektrische Funken 4 nicht symmetrisch zur Längsachse des Drahtes, was tendenziell zur Bildung von asymmetrischen Drahtkugeln führt. Allerdings weist die Asymmetrie dieser Drahtkugeln eine Vorzugsrichtung aus. Dies ermöglicht es, die Asymmetrie mit zusätzlichen Massnahmen zu reduzieren. Diese Anordnung erfordert zudem eine im Vergleich zum ersten Typ höhere Funkenspannung. Dies führt bei gleichem vertikalem Abstand zur Niederhalteplatte, die sich unmittelbar unterhalb der Vorrichtung befindet und die Anschlussfinger des Substrates fixiert, zu einer grösseren Häufigkeit von elektrischen Durchschlägen auf die Niederhalteplatte.

Beim dritten Typ (Fig. 3) ist die Elektrode 1 eine rotationssymmetrische Lochelektrode. Nach der Bildung der Drahtkugel wird die Kapillare 3 durch die Elektrode hindurch abgesenkt. Der Vorteil dieser Anordnung ist, dass die zur Bildung des elektrischen Funkens nötige Spannung geringer als bei den ersten beiden Typen ist. Der Nachteil ist, dass der Ort, wo der elektrische Funken 4 entsteht, ständig variiert. Auch mit dieser Vorrichtung erzeugte Drahtkugeln neigen zu Asymmetrien, allerdings weisen diese Asymmetrien keine Vorzugsrichtung auf.

Aus der europäischen Patentanmeldung EP 562 224 ist eine weitere Vorrichtung für die Bildung einer Drahtkugel bekannt. Diese Vorrichtung weist drei spitzige Elektroden auf, die elektrisch separat angesteuert werden, um die durch die einzelnen Elektroden fliessenden Ströme zu regeln.

Der Erfindung liegt die Aufgabe zugrunde, eine Vorrichtung für die Bildung einer Kugel am Ende eines Drahtes zu entwickeln, die sich durch eine möglichst tiefe Funkenspannung auszeichnet und mit der sich Drahtkugeln erzeugen lassen, deren Grösse möglichst wenig streut.

Die genannte Aufgabe wird erfindungsgemäss gelöst durch die Merkmale des Anspruchs 1.

Eine erfindungsgemässe Vorrichtung weist eine erste Elektrode, die mit einer Spitze versehen ist, und mindestens eine zusätzliche Elektrode auf. Die zweite Elektrode, bzw. die weiteren Elektroden, beeinflusst den Verlauf des elektrischen Feldes, das sich zwischen dem Ende des Drahtes und den Elektroden ausbildet. Alle Elektroden sind elektrisch miteinander verbunden und liegen somit auf dem gleichen elektrischen Potenzial. Sie sind zudem so ausgebildet und so angeordnet, dass der Abstand zwischen der Spitze der ersten Elektrode und dem Draht in jedem Fall kleiner ist als der Abstand zwischen der zweiten Elektrode, bzw. allen weiteren Elektroden, und dem Draht. Auf diese Weise wird sichergestellt, das nur ein einziger elektrischer Funken erzeugt wird, nämlich zwischen dem Draht und der Spitze der ersten Elektrode. Der Vorteil der mindestens einen zusätzlichen Elektrode liegt darin, dass sich eine deutlich geringere Funkenspannung als im Stand der Technik ergibt. Infolgedessen kann der Abstand zwischen den Elektroden und der Niederhalteplatte verringert werden, ohne die Gefahr von Durchschlägen zu erhöhen. Für die Bildung der Drahtkugel muss deshalb auch die Kapillare weniger weit angehoben werden, so dass sich die Zykluszeit reduziert.

Die mindestens eine zusätzliche Elektrode kann offen sein, d.h. ein offenes Ende, mit oder ohne Spitze, haben. Vorteilhafterweise ist die mindestens eine zusätzliche Elektrode jedoch eine geschlossene Elektrode, beispielsweise eine ringförmige Elektrode. Eine geschlossene Elektrode hat den Vorteil, dass die Streuung der Funkenspannung geringer ist als bei einer offenen Elektrode, was zu einer geringeren Streuung der Grösse der Drahtkugel führt.

Nachfolgend werden Ausführungsbeispiele der Erfindung anhand der Zeichnung näher erläutert. Die Figuren sind nicht massstäblich gezeichnet.

Es zeigen:
- Fig. 1-3: drei Typen von Vorrichtungen zur Bildung einer Drahtkugel am Ende eines Drahtes aus dem Stand der Technik, und
- Fig. 4-7: drei verschiedene Ausführungsbeispiele einer erfindungsgemässen Vorrichtung zur Bildung einer Drahtkugel am Ende eines Drahtes, und
- Fig. 8: ein elektrisches Ersatzschema.

Die Fig. 4 zeigt in perspektivischer Ansicht ein erstes Ausführungsbeispiel einer erfindungsgemässen Vorrichtung zur Bildung einer Drahtkugel am Ende eines Drahtes 2, wie sie auf einem Wire Bonder verwendet werden kann. Der Draht 2 wird wie in der Einleitung beschrieben von einer Kapillare 3 geführt. Am Beginn eines Bondzyklus ragte ein Ende des Drahtes 2 aus der Spitze 5 der Kapillare 3 heraus. Dieses Drahtende ist nun zu einer Kugel zu formen. Die Vorrichtung weist drei Elektroden 6 - 8 auf, die elektrisch miteinander verbunden sind und somit das gleiche elektrische Potenzial aufweisen. Die erste Elektrode 6 ist mit einer Spitze 9 ausgebildet. Wenn die Kapillare 3 angehoben worden ist und sich bezüglich der Vorrichtung in der Position befindet, in der die Drahtkugel gebildet werden soll, dann befindet sich die Spitze 9 der ersten Elektrode 6 seitlich versetzt unterhalb der Spitze der Kapillare 3. In der Fig. 4 befindet sich die Spitze 9 der ersten Elektrode 6 auf der einen, nämlich der rechten Seite der Kapillare 3. Die zweite Elektrode 7 und die dritte Elektrode 8 sind länger als die erste Elektrode 6 und reichen bis auf die andere Seite der Kapillare 3, im Beispiel der Fig. 4 also bis auf die linke Seite der Kapillare 3. Der Abstand zwischen einem beliebigen Punkt der zweiten Elektrode 7 und dem Ende des Drahtes 2 wie auch der Abstand zwischen einem beliebigen Punkt der dritten Elektrode 8 und dem Ende des Drahtes 2 ist grösser als der maximale Abstand zwischen der Spitze 9 der ersten Elektrode 6 und dem Ende des Drahtes 2. Zu beachten ist dabei, dass die Länge des aus der Kapillare 3 herausragenden Drahtstückes gewissen Schwankungen unterliegt und dass dieses Drahtstück in eine beliebige Richtung zeigen kann.

Die zweite und dritte Elektrode 7 und 8 sind ohne Kanten auszubilden, da sich an Kanten Spitzen des elektrischen Feldes bilden können. Diese Einschränkung gilt allerdings nur für denjenigen Bereich der Vorrichtung, wo das elektrische Feld vergleichsweise gross ist. Die Einschränkung gilt also nicht für diejenigen Teile der Elektroden 7 und 8, die am weitesten von der Spitze 5 der Kapillare 3 entfernt sind. Der Querschnitt der zweiten und dritten Elektrode ist deshalb bevorzugt kreisförmig.

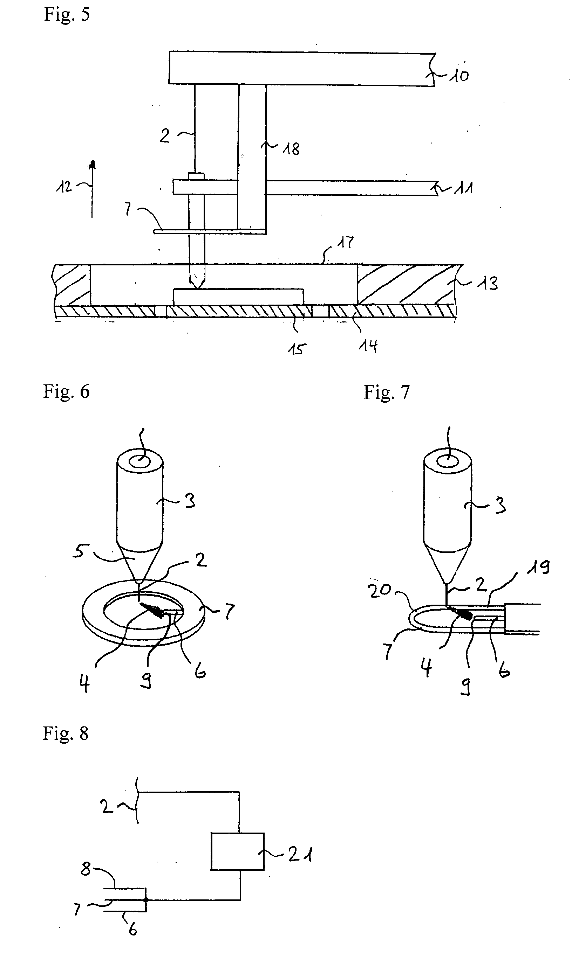

Die Fig. 5 zeigt die auf einem Wire Bonder eingesetzte Vorrichtung in seitlicher Ansicht. Der Wire Bonder umfasst einen Bondkopf 10 mit einem Horn 11, an dessen Spitze die Kapillare 3 eingespannt ist. Das Horn 11 ist gegenüber dem Bondkopf 10 in vertikaler Richtung 12 verschiebbar. Unterhalb der Vorrichtung befindet sich eine sogenannte Niederhalteplatte 13, mit der Anschlussfinger 14 eines Substrates 15, auf dem ein Halbleiterchip 16 montiert ist, fixiert werden. Im gezeigten Beispiel befinden sich die drei Elektroden 6 - 8 in einer Ebene (nur die Elektrode 7 ist sichtbar), die parallel zur Oberfläche 17 der Niederhalteplatte 13 verläuft. Es ist aber auch möglich, die beiden Elektroden 7 und 8 in einer anderen Ebene als die erste Elektrode 6 anzuordnen. Die Elektroden 6 - 8 sind über einen isolierenden Körper 18 am Bondkopf 10 befestigt. Die Kapillare 3 ist auf einen Anschlusspunkt auf dem Halbleiterchip 16 abgesenkt.

Die Fig. 6 zeigt in perspektivischer Ansicht ein zweites Ausführungsbeispiel einer erfindungsgemässen Vorrichtung zur Bildung einer Drahtkugel am Ende eines Drahtes 2. Diese Vorrichtung weist nur die erste Elektrode 6 und die zweite Elektrode 7 auf. Die erste Elektrode 6 ist wiederum mit der Spitze 9 versehen. Die zweite Elektrode 7 ist ringförmig und somit eine geschlossene Elektrode. Die beiden Elektroden 6 und 7 befinden sich in einer Ebene, die unterhalb der Spitze 5 der Kapillare 3 und parallel zur Oberfläche 17 (Fig. 5) der Niederhalteplatte 13 verläuft. Das Zentrum der ringförmigen Elektrode 7 befindet sich unterhalb der Spitze 5 der Kapillare 3. Die erste Elektrode 6 ist länger als die maximale Länge des aus der Kapillare 3 herausragenden Drahtabschnittes. Der elektrische Funken 4 entsteht daher immer zwischen der Spitze 9 der ersten Elektrode 6 und dem Draht 2. Die Ränder des Ringes der Elektrode 7 sind bevorzugt abgerundet, d.h. ohne Kanten ausgebildet. Diese Eigenschaft ist aus der Fig. 6 allerdings nicht ersichtlich.

Die Fig. 7 zeigt in perspektivischer Ansicht ein drittes Ausführungsbeispiel einer erfindungsgemässen Vorrichtung zur Bildung einer Drahtkugel am Ende eines Drahtes 2. Auch diese Vorrichtung weist nur die erste Elektrode 6 und die zweite Elektrode 7 auf. Die erste Elektrode 6 ist wiederum mit der Spitze 9 versehen. Die zweite Elektrode 7 besteht aus zwei parallel zur ersten Elektrode 6 verlaufenden Abschnitten 19, die durch einen Bogen 20 verbunden sind. Die zweite Elektrode 7 ist also auch eine geschlossene Elektrode. Die beiden Elektroden 6 und 7 befinden sich in einer Ebene, die unterhalb der Spitze 5 der Kapillare 3 und parallel zur Oberfläche 17 (Fig. 5) der Niederhalteplatte 13 verläuft. Die beiden Elektroden 6 und 7 sind wiederum so dimensioniert und angeordnet, dass der elektrische Funken 4 immer zwischen der Spitze 9 der ersten Elektrode 6 und dem Draht 2 entsteht.

Nach der Bildung der Drahtkugel wird die Kapillare 3 zwischen den offenen Elektroden 7 und 8 (Ausführungsbeispiel 1) hindurch bzw. durch die geschlossene Elektrode 7 (Ausführungsbeispiele 2 und 3) hindurch auf den entsprechenden Anschlusspunkt auf dem Halbleiterchip 16 abgesenkt und die Drahtkugel dort befestigt.

Die Fig. 8 zeigt das elektrische Ersatzschema. Der Draht 2 und alle Elektroden 6 - 8 beim ersten Ausführungsbeispiel bzw. 6 und 7 beim zweiten und dritten Ausführungsbeispiel sind durch einen an sich aus dem Stand der Technik bekannten Funkengenerator 21 verbunden. Der Funkengenerator besteht im wesentlichen aus einer Konstantstromquelle. Um den elektrischen Funken 4 zwischen dem Drahtende und der ersten Elektrode 6 bilden zu können, muss die dazwischen liegende Luft ionisiert werden, bis ein elektrischer Durchschlag stattfindet und somit der Funken 4 entsteht. Dazu wird über der Konstantstromquelle eine zunehmende Gleichspannung aufgebaut, bis der Durchschlag erfolgt. Für die Grösse der gebildeten Drahtkugel sind zwei hauptsächlich Faktoren massgebend. Der eine Faktor ist die elektrische Energie, die im Verbindungskabel zwischen der Konstantstromquelle und den Elektroden 6 - 8 beim Aufbau der Gleichspannung erzeugt und gespeichert wird. Sobald der elektrische Funken 4 gebildet ist, wird diese Energie in der sich bildenden Drahtkugel entladen. Der zweite Faktor ist die von der Konstantstromquelle von der Funkenbildung bis zum Abschluss des Kugelbildungsprozesses gelieferte Strommenge, die durch die vorgegebene Stromstärke und die Zeitdauer gesteuert werden kann. Die Energie, die im Verbindungskabel aufgebaut wird und bei der Entstehung des Funkens gespeichert ist und sich dann entlädt, kann nicht kontrolliert werden. Die erfindungsgemässen Vorrichtungen haben den Vorteil, insbesondere wenn die zweite Elektrode 7 eine geschlossene Elektrode ist, dass einerseits die Funkenspannung und andererseits auch deren Streuung wesentlich geringer ist als beim Stand der Technik. Die stark reduzierte Streuung der Funkenspannung hat eine ebensolche Reduzierung der Streuung der im Verbindungskabel bis zur Entladung gespeicherten Energie und damit auch eine Reduzierung der Streuung der Grösse der geformten Drahtkugel zur Folge.

## Patentansprüche

1. Vorrichtung mit Elektroden für die Bildung einer Kugel am Ende eines aus einer Kapillare (3) herausragenden Drahtes (2), **dadurch gekennzeichnet, dass** eine erste Elektrode (6) vorhanden ist, die mit einer Spitze (9) versehen ist, und dass mindestens eine weitere Elektrode (7; 8) vorhanden ist, wobei die erste Elektrode (6) und die mindestens eine weitere Elektrode (7; 8) elektrisch verbunden sind und wobei der Abstand zwischen der Spitze (9) der ersten Elektrode (6) und dem Ende des Drahtes (2) grösser ist als der Abstand zwischen einem beliebigen Punkt der mindestens einen weiteren Elektrode (7; 8) und dem Ende des Drahtes (2).

2. Vorrichtung nach Anspruch 1, **dadurch gekennzeichnet, dass** eine einzige weitere Elektrode (7) vorhanden ist und dass die einzige weitere Elektrode (7) eine geschlossene Form aufweist.
